# EUROPEAN PATENT SPECIFICATION

(11) **EP 2 765 428 B1**
(45) Date of publication and mention of the grant of the patent: **25.09.2019**
(21) Application number: 14150931.5
(22) Date of filing: 13.01.2014
(51) Int. Cl.: G01R 31/02

(54) **Device for automatic testing of power capacitors**
Dispositif pour des tests automatiques des condensateurs de puissance
Gerät zur automatischen Prüfung der Leistungskondensatoren

(30) Priority: 07.02.2013 CZ 20130084
(43) Date of publication of application: 13.08.2014
(73) Proprietor: Czech Technical University in Prague, 16627 Praha 6 (CZ)
(72) Inventor: Papez , M Václav, 10000 Praha 10 (CZ)
(74) Representative: Kratochvil, Vaclav

(56) References cited:
- EP-A1- 0 792 465
- EP-A1- 2 339 726
- CN-A- 102 736 000
- CN-U- 202 721 445
- JP-A- H06 213 978
- US-A- 3 970 925
- ABDENNADHER K ET AL: "A Real Time Predictive Maintenance System of Aluminium Electrolytic Capacitors Used in Uninterrupted Power Supplies", INDUSTRY APPLICATIONS SOCIETY ANNUAL MEETING, 2008. IAS '08. IEEE, IEEE, PISCATAWAY, NJ, USA, 5 October 2008 (2008-10-05), pages 1-6, XP031353895, ISBN: 978-1-4244-2278-4

## Description

### Background of the Invention

Presented solution deals with a design, which allows to test power capacitors in the mode when the alternating current passes through them, usually with high frequency and units up to tens of amperes, while the needed electric power and demands for the testing equipment are minimized.

### Description of Prior Art

With the exception of the breakdown voltage testing, the capacitors are factory tested usually with low-level signals. The procedure is based on presumption that the tested capacitor is linear thus allowing to extrapolate the dependencies found using the low-level testing signals and the high-level signals up to the highest permissible values. In this way many methods, such as measuring the impedance or admittance, bridge measuring methods or measurements in oscillating circuits, can be used automaticlly during production outler check of components, for measuring the capacitance, the capacitance temperature dependence, the capacitance dependence on the applied direct current voltage, loss factor or capacitor quality factor, isolating resistance and equivalent series resistance of the capacitor in wide range of measured values as well as measuring frequencies.

More complicated the situation is when verifying the maximum permissible values of the capacitor load, for example by applied alternating voltage or passing current at defined frequencies and temperatures. The primary objective of the test is not to measure the parameters of the tested component, but to determine the effect of the operating load on these parameters and, in particular, on the foreseeable life of the component. Under these conditions, the component is no longer consistently linear, it warms up due to electrical losses, and the thermal dependence of the parameters caused by the input signal occurs.

Here the testing is made in individually created testing circuits designed in such a way to ensure that the circuit parameters of the testing circuit in operation are as close as possible to the defined parameters of the test.

The capacitors are loaded with a test signal that is fed directly to the tested capacitor and is withdrawn from the power mains or is generated by a power generator or by a generator coupled with a power amplifier. The voltage values on the tested capacitor and the current passing through the tested capacitor are typically measured and automatically stored in order to document the testing procedure, to evaluate the parameters of the tested capacitor during the test, or to be used to stabilize the selected test parameters.

Capacitors designed for use in equipment of a particular kind are sometimes tested in testing circuits that are similar to the circuits, in which they will be used in operation. Such a system designed to test the electrolytic capacitors used in Uninterrupted Power Supplies with a practically constant DC voltage load and a pulse current in the boost-converter circuit is described in Abdennadher Karim et al. "A Real-Time Predictive-Maintenance System of Aluminum Electrolytic Capacitors Used in Uninterrupted Power Supplies", Industry Applications Society Annual Meeting, 2008.

A similar device for testing the DC charged capacitors is described in JPH062 13978. The capacitor charged to the DC voltage is discharged by a transient process whose parameters are determined by the given damped oscillating circuit. Systems of this kind are well-suited for testing a narrow range of components that are used in certain devices, in this case electrolytic capacitors with a capacity from 470 to 4700 µF at a voltage of 200 to 500 V for use in Uninterrupted Power Supplies, and are not usable for testing other components, such as capacitors with foil dielectrics, which are tested with alternating current and voltage.

Measurement in the oscillating circuit is described in US2759146A. This device is based on the principle of common Q-meter, which is automatically set by means of a variable capacitor controlled by servomotor to oscillation at the selected measuring frequency. The device is designed to test capacitors, but since the oscillating circuit is coupled with generator via the resistance network, it cannot be used for testing power capacitors with reactive capacitances in orders of units and tens of kVAr. This device is not usable for testing capacitors with a capacitance in orders of units up to tens of µF. A variable capacitor with a maximum capacitance of several thousand pF can in an ideal case provide fine tuning of an oscillating circuit with a capacitance of a few tenths of µF at the most.

In order to test power capacitors, the testing circuit has in addition to be designed as a power electric device, it means taking into consideration the electric stress of all elements involved and their cooling, and it must be supplied by a high-power signal. Ideally, this power is real and corresponds to the power lost in all components of the testing circuit and in the tested capacitor. In general case, the testing circuit takes off also the reactive power, which is roughly equal to the reactance power of the capacitor and may be even by three orders higher than the real power. Viewed from the testing circuit power supply standpoint, for the apparent power higher than several VA this situation is permissible only when the testing circuit is supplied by alternating voltage with the frequency of the electric power mains directly from the electric power mains and the reactive power is either taken off from the mains or is compensated in the mains.

Rather complicated are solutions for the power supply of testing circuits with the apparent power higher than hundreds of VA and low power factor and at frequencies other than the mains frequency, which usually must be realized by implementing the linear power amplifier. When drawing the reactive power, the amplifier is overloaded heavily. If the current and voltage in the reactance load correspond to the presumed current and voltage in the rated real power load, the power losses in the amplifier reach 130 to 150% of taken-off reactive power. This implies that the amplifier must be sized to withstand the real power approximately 2.5 times higher than the reactive power if the amplifier should not be inevitably damaged by the reactive power. Where the tests are performed on a long-term basis, significant setback is also high electric power consumption.

US3970925 discloses a reactance meter for a resonant circuit including phase detection for adjusting the output of an oscillator.

### Summary of the Invention

Disadvantages mentioned above are removed by the device for automatic testing of power capacitors according to the presented invention.

The device includes an oscillator, and the tested power capacitor is inserted in an LC oscillating circuit. The principle of the new solution is that the tested power capacitor is complemented with an inductor with loss factor equal or lower than the loss factor of the tested capacitor to form an LC oscillating circuit. The inductor's inductance at the oscillating frequency has the same reactance value as the tested power capacitor. The oscillating circuit is interconnected both with the first sensor for monitoring the status of tuning of the oscillating circuit where the output of this first sensor is connected to the input of the regulating amplifier, and with one input of the phase detector. Simultaneously, the oscillating circuit is interconnected with the second sensor for monitoring the status of tuning of the oscillating circuit. The output of this second sensor is connected to the second input of the phase detector. The output of the phase detector is via an integrating amplifier for automatic setting of frequency to the oscillating frequency of the oscillating circuit connected to the voltage-controlled oscillator, the output of which is connected to the signal input of the adjustable attenuating element. To the control input of the adjustable attenuating element is connected the output of the regulating amplifier for automatic setting the signal level in the tested power capacitor. The output of the adjustable attenuating element is connected via the power amplifier to the input of the first sensor and to the input of the second sensor.

For testing the power capacitors with high capacitance, the oscillating circuit is implemented as a parallel oscillating circuit. The first sensor is formed by the first current sensor and it is connected in series to the tested power capacitor. The second sensor is formed by the second current sensor, which is connected between the output of the power amplifier and the common connecting point of the tested capacitor and inductor. In an advantageous embodiment, the power amplifier is connected to the parallel oscillating circuit via a matching transforming element, while the output earthing clamp of this matching transforming element is connected to the hub formed by the connection of the first current sensor with the inductor. The output live clamp of the matching transforming element is connected to the input of the second current sensor.

For testing the power capacitors with low capacitance, the oscillating circuit is implemented as a series oscillating circuit. The first sensor is formed by the first voltage sensor and it bridges the tested power capacitor. The second sensor is formed by the second voltage sensor and it is connected in parallel to the series oscillating circuit. The common connecting point of the second voltage sensor and the inductor is connected to the output of the power amplifier. In an advantageous embodiment, the power amplifier is connected to the series oscillating circuit via a matching transforming element. Its output earthing clamp is connected to the hub formed by the connection of the input of the first voltage sensor, the second voltage sensor and the tested power capacitor. The output live clamp of the matching transforming element is connected to the hub formed by the connection of the second voltage sensor and the inductor.

The invention is defined as following:
Device for automatic testing of power capacitors comprising
- an inductor, arranged such that it forms, together with the power capacitor to be tested, a parallel or serial LC oscillating circuit, when the capacitor to be tested is connected to the device;
- a first sensor arranged for monitoring acurrent or voltage signalacross the capacitor to be measured;
- a second sensor arranged for monitoring acurrent or voltage across the LC oscillating circuit;
- a phase detector, whose first and second inputs are connected to the outputs of the first sensor and second sensor, respectively, the phase detector being configured to detect the phase difference between the output signals of the first sensor and the second sensor and to determine the deviation of said phase difference from 90°;
- an integrating amplifier and a voltage controlled oscillator, arranged such that the output of the phase detector is supplied via the integrating amplifier to the control input of the voltage-controlled oscillator, the voltage-controlled oscillator being configured to tune the frequency of its output signal to the resonance frequency of the LC oscillating circuit based on the determined phase deviation;
- a regulating amplifier, whose input is connected to a second output of the first sensor;
- a power amplifier and an adjustable attenuating element, wherein the signal input of the adjustable attenuating element is connected to the output of the voltage-controlled oscillator and
- wherein the control input of the adjustable attenuating element is connected to the output of the regulating amplifier for setting the power level of the signal applied via the power amplifier to the LC oscillating circuit such that it remains at a reference value;
said device being arranged such that the reactance of the inductor at the resonance frequency of the LC oscillating circuit matches the reactance of the capacitor to be tested.

The principle of the invention is to test the capacitor, which for this purpose is inserted in a quality oscillating circuit.

Since the critical condition for function is that the oscillating frequencies of the oscillating circuit and the operational frequency of the system are equal, the system presented in the invention is equipped with circuits for automatic frequency adjustment, which allow its automatic operation.

The concept of the system is based on arrangement of the impedance phasor sensor, which when powered by the signal generator represented here by the voltage-controlled oscillator, evaluates the voltage and current, or rather their ratio and phase shift respectively.

The system for automatic testing of power capacitors is designed as a power electrical device for processing signals with levels approximately 3 orders higher than the impedance meters, and it further contains two control loops for controlling the frequency of the testing signal and the signal level on the tested capacitor.

The main difference in principle between the presented solution and document US2759146A is that the oscillating frequency of the measuring oscillating circuit and the frequency of the measuring signal are according to the invention identified in the device by varying the frequency of the measuring signal, not by changing the capacitance in the measuring oscillating circuit.

The advantage of the new solution is highly accurate compensation of the reactive power of the tested capacitor in the measuring circuit and matching the measuring circuit with the exciter generator. This allows to reach the condition when the exciter generator supplies no reactive power and the delivered real power, covering losses in the measuring circuit elements, is by 1 to 2 orders lower than the reactive power of the tested capacitor. The described solution ensures the needed precise compensation of the tested capacitor's reactive power, which can be viewed as complementing the tested capacitor with the inductor in a way that creates an oscillating circuit tuned at the testing frequency, by automatic correction of the measuring frequency according to instantaneous value of the oscillating frequency of the measuring circuit. The frequency is controlled by a feedback loop with the voltage-controlled oscillator, integrator and phase detector. The signals led to the inputs of the phase detector are taken from the measuring circuit, e.g. as the excitation current of the parallel oscillating circuit and the current in the capacitance branch of the oscillating circuit, in such way that at oscillation they correspond to two sinusoidal signals with phase shift of 90°. If out of tune, when the phase shift is not 90°, the output signal of the phase detector in the loop causes through the integrator an action of the voltage-controlled oscillator and makes it change the frequency it generates towards the oscillating frequency of the measuring circuit.

### Explanation of Drawings

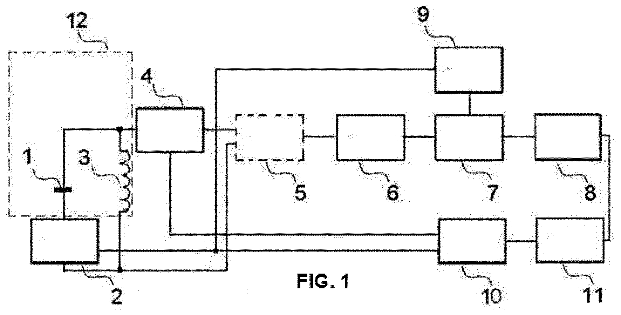

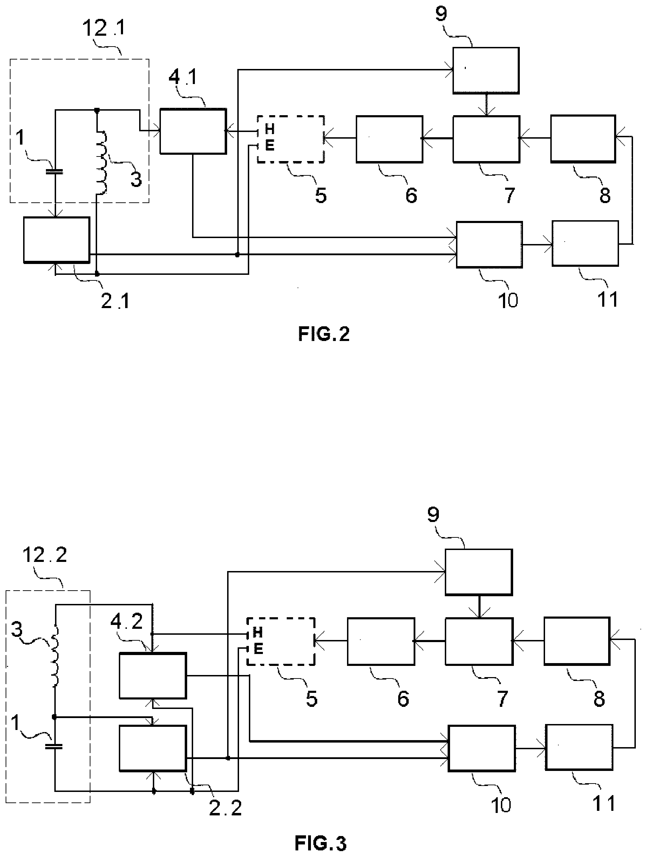

Fig. 1 shows a general block digram for automatic testing of power caacitors. Examples of the block layout of both versions of the device for automatic testing of power capacitors are shown in attached drawings. Version with the parallel oscillating circuit is in fig. 2 and version with the series oscillating circuit is in fig. 3.

### Detailed Description of the Preferred Embodiment

General block diagram for automatic testing of power capacitors is shown in fig. 1. The tested power capacitor 1 is complemented with an inductor 3 with loss factor equal or lower than the loss factor of the tested capacitor 1 to form an LC oscillating circuit 12. The value of inductance of the inductor 3 at the measuring frequency has the same reactance as the tested power capacitor 1. The oscillating circuit 12 is interconnected with the first sensor 2 and the second sensor 4, which are designed to monitor the status of oscillating circuit 12 tuning. The output of the first sensor 2 is connected to the control input of the regulating amplifier 9 and to one input of the phase detector 10. The output of the second sensor 4 is connected to the second input of the phase detector 10. The output of the phase detector 10 is via an integrating amplifier 11 for automatic setting of frequency to the oscillating frequency of the oscillating circuit 12 connected to the voltage-controlled oscillator 8, the output of which is connected to the signal input of the adjustable attenuating element 7, and to the control input of the adjustable attenuating element 7 is connected the output of the regulating amplifier 9 for automatic setting the signal level in the tested power capacitor 1. The output of the adjustable attenuating element 7 is connected via the power amplifier 6 to the oscillating sensor 12.

The device has two versions, which will be described below.

Layout of the device for automatic testing of power capacitors suitable especially for power capacitors with high capacitance, which are tested using the current with tens or even hundreds of A, is shown in fig. 2. The tested power capacitor 1 is complemented with an inductor 3 with low losses, the inductance of which is selected such that at the testing frequency it has the same reactance as the tested power capacitor 1, to form a parallel oscillating circuit 12.1, in which at the circuit's oscillating frequency the capacitance reactive power of the tested power capacitor 1 is compensated by the inductance reactive power of the inductor 3. In the series combination with the tested power capacitor 1, which is connected in parallel with the inductor 3, is inserted the first current sensor 2.1 by its input terminals. The output of the first current sensor 2.1 is connected both to the control input of the regulating amplifier 9 and to one input of the phase detector 10. To one of the connections between the created parallel oscillating circuit 12.1 and the output of the power amplifier 6 is connected the second current sensor 4.1 by its input terminals. Its output is connected to the second input of the phase detector 10. The output of the phase detector 10 is via the integrating amplifier 11 and voltage-controlled oscillator 8 connected to signal input of the adjustable attenuating element 7. To the control input of the adjustable attenuating element 7 is connected the output of the regulating amplifier 9. The output of the adjustable attenuating element 7 is in the basic design connected via the power amplifier 6 to the common connection of the inductor 3 and the first current sensor 2.1 and to the second input of the second current sensor 4.1, while its first input is connected to the common connecting point of the tested power capacitor 1 and the inductor 3. In connection according to the fig. 2 is this power amplifier 6 connected to the parallel oscillating circuit 12.1 formed by the tested power capacitor 1 and the inductor 3 via the matching transforming element 5, while its output earthing clamp E is connected to the hub formed by the connection of the first current sensor 2.1 with the inductor 3, and where the output live clamp H of the matching transforming element 5 is connected to the input of the second current sensor 4.1..

The testing signal is generated by the voltage-controlled oscillator 8, from which it is led to the adjustable attenuating element 7, power amplifier 6, in the given example also to the matching transforming element 5, and from here up to the parallel oscillating circuit with the power capacitor 1 and the inductor 3. The in-tune condition of the oscillating circuit is monitored by the current sensors, it means the first current sensor 2.1 and the second current sensor 4.1, while their output signals reflect the current in the tested power capacitor 1 and the excitation current of the parallel oscillating circuit. Both these signals are led to the phase detector 10 where its output signal is proportionate to the deviation of the phase shift between the incoming signals from the value of 90°. The output signal of the phase detector 10 is led to the integrating amplifier 11, which generates a control signal that automatically sets the frequency of the voltage-controlled oscillator 8 to the oscillating frequency of the measuring circuit. The output signal of the first current sensor 2.1 is then led to the regulating amplifier 9 where the signal level is compared with the reference level and based on the difference the control signal for the adjustable attenuating element 7 is generated, which continuously sets the input voltage of the power amplifier 6 to the value, at which the current in the power capacitor 1 reaches desired value.

Matching the oscillating resistance of the oscillating circuit with the optimal load resistance of the signal source is provided by the matching transforming element 5, which is inserted between the power amplifier 6 and the measuring oscillating circuit. Transformation ratio of the matching transforming element 5 is chosen such that the oscillating resistance of the oscillating circuit at oscillation, which it transforms, corresponds to the optimal load resistance of the power amplifier 6.

Layout of the device for automatic testing of power capacitors suitable especially for power capacitors with lower capacitance, which are tested using the current of several A and during testing they feature voltage up to several thousand V, is shown in fig. 3. The capacitance reactance of the power capacitor 1 is at the testing frequency higher than the optimal load resistance of the power amplifier 6. In this case the tested power capacitor 1 is complemented with inductor 3 with low losses, the loss factor of which is comparable with the loss factor of the tested power capacitor 1 or lower, to form a series oscillating circuit 12.2. The inductance of the inductor is selected such that at the testing frequency it has the same reactance as the tested power capacitor 1. In thus created series oscillating circuit 12.2 the capacitance reactive power of the capacitor at the oscillating frequency is compensated by the inductance reactive power of the inductor. The inductor 3 is bridged with the first voltage sensor 2.2, the output of which is connected both to the input of the regulating amplifier 9 and to one input of the phase detector 10. In parallel with this series oscillating circuit 12.2 is connected the second voltage sensor 4.2, the output of which is connected to the second input of the phase detector 10. The output of the phase detector 10 is via the integrating amplifier 11 and the voltage-controlled oscillator 8 connected to the signal input of the adjustable attenuating element 7. To the control second input of the adjustable attenuating element 7 is connected the output of the regulating amplifier 9. The output of the adjustable attenuating element 7 is connected to the input of the power amplifier 6, the output of which is in the given example connected to the series oscillating circuit formed by the tested power capacitor 1 and the inductor 3 via the matching transforming element 5, while its output earthing clamp E is connected to the hub formed by the connection of the first voltage sensor 2.2, the input of the second voltage sensor 4.2 and the tested power capacitor 1, and where the output live clamp H of the matching transforming element 5 is connected to the hub formed by the connection of the second input of the second voltage sensor 4.2 and the inductor 3.

The testing signal is again generated by the voltage-controlled oscillator 8, from which it is led to the adjustable attenuating element 7, power amplifier 6, the matching transforming element 5, and from here up to the series oscillating circuit 12.2 with the power capacitor 1 and the inductor 3. The in-tune condition of the series oscillating circuit 12.2 is monitored by the voltage sensors, it means the first voltage sensor 2.2 and the second voltage sensor 4.2, while their output signals reflect the voltage at the tested power capacitor 1 and the excitation voltage of the series oscillating circuit 12.2. Both these signals are led to the phase detector 10 where its output signal is proportionate to the deviation of the phase shift between the incoming signals from the value of 90°. The output signal of the phase detector 10 is led to the integrating amplifier 11, which generates a control signal that automatically sets the frequency of the voltage-controlled oscillator 8 to the oscillating frequency of the measuring circuit. The output signal of the first voltage sensor 2.2 is then led to the regulating amplifier 9 where its level is compared with the reference level and based on the difference the control signal for the adjustable attenuating element 7 is generated, which continuously sets the input voltage of the power amplifier 6 to the value, at which the voltage at the power capacitor 1 reaches desired value. The matching transforming element 5 here has the same role as in the design according to the fig. 2.

The principle of function of the device for automatic testing of power capacitors is excitation of desired high reactive power in the tested power capacitor 1, which is part of an oscillating circuit, by action of many times lower real power, which covers the losses in the power capacitor 1 and the inductor 3 of the oscillating circuit. Because modern and quality capacitors with dielectrics made of plastic foils feature within the range of measuring frequencies from 1 to 100 kHz low loss factor with the order 10⁻³, the power losses of the testing circuit do not usually exceed 100 W.

If the oscillating circuit is precisely tuned at the measuring frequency, it is possible to use the real power of 100 W to create the reactive power in the tested power capacitor 1 at the level of 5 to 10 kVAr. Automatic ensuring that the in-tune condition is permanently fulfilled, matching the oscillating resistance of the oscillating circuit with the optimal load resistance of the signal source and stabilization of the signal level in the measuring circuit are the basic functions of the device for automatic testing of power capacitors.

The loop providing the automatic fine tuning sets the instantaneous value of the measuring frequency to the oscillating frequency of the oscillating circuit, which during testing may slightly vary due to the capacitor's ageing, change of its capacitance or change of the inductor's inductance. With respect to the quality factor of the measuring oscillating circuit, which may reach even values higher than 100, even the variation in order of tenths % between the measuring frequency and the oscillating frequency of the measuring circuit considerable variation of the oscillator circuit impedance from the real value. Because automatic electronic setting of inductance or capacitance in the measuring circuit would be difficult and costly, it is the measuring frequency that is being set to the oscillating frequency. If the change of the measuring frequency is low, usually not over 1%, then also the changes of measuring conditions caused by such change are negligible.

The oscillation conditions in the oscillating circuit formed by the capacitor 1 and the inductor 3 are monitored by means of current sensors 2.1, 4.1 or voltage sensors 2.2, 4.2, while their output signals reflect the current or voltage on the tested power capacitor 1 and the excitation current or excitation voltage of the oscillating circuit. Output signals of the current sensors 2.1, 4.1 or voltage sensors 2.2, 4.2 are led to the phase detector 10, which functions as an analogue multiplier, its output voltage is zero provided that the phase shift of the input signals is 90° and provided that the oscillating circuit is tuned at the frequency of the excitation signal. For other and small deviations of the phase shift from 90°, if the oscillating circuit is not tuned at the excitation signal frequency, the output voltage is proportionate to the size of actual phase shift from 90°, or also to the deviation of the oscillating frequency of the oscillating circuit from the excitation signal frequency respectively. Output signal of the phase detector 10 is therefore used as the input quantity in the loop providing automatic fine tuning and is led to the integrating amplifier 11, which generates the control signal used to automatically set the frequency of the voltage-controlled oscillator 8 to the oscillating frequency of the measuring circuit.

The loop providing stabilization of the signal level in the measuring circuit ensures long-term constant level of the signal on the tested power capacitor 1 even during minor changes of the measuring circuit parameters. Output signal of the first current sensor 2.1, or of the first voltage sensor 2.2 respectively, which represents the signal level on the tested power capacitor 1, is evaluated and compared with the reference level in the regulating amplifier 9. Here, based on the difference of its level fro the reference level, control signal is generated and led to the adjustable attenuating element 7 and its attenuation is adapted according to the level of the control voltage. This ensures continuous adjusting of the input voltage of the power amplifier 6 to the value, at which the current in the tested power capacitor 1 reaches desired value.

### Industrial Applicability

The device according to the presented solution is a device for automatic testing of power capacitors that can be deployed in all cases where quality capacitors are subject to long-term tests, e.g. during the life cycle testing, by reactive power higher than several tens VAr. The device allows for testing with lower power of the excitation signal generator and with lower electric power consumption than other solutions. In addition, the device allows for stabilization of the tested capacitor load level during testing.

## Claims

1. Device for automatic testing of power capacitors comprising
- an inductor (3), arranged such that it forms, together with the power capacitor to be tested (1), a parallel or serial LC oscillating circuit (12), when the capacitor to be tested (1) is connected to the device;
- a first sensor (2) arranged for monitoring acurrent or voltage signalacross the capacitor to be measured (1);
- a second sensor (4) arranged for monitoring acurrent or voltage across the LC oscillating circuit (12);
- a phase detector (10), whose first and second inputs are connected to the outputs of the first sensor (2) and second sensor (4), respectively, the phase detector (10) being configured to detect the phase difference between the output signals of the first sensor (2) and the second sensor (4) and to determine the deviation of said phase difference from 90°;
- an integrating amplifier (11) and a voltage controlled oscillator (8), arranged such that the output of the phase detector (10) is supplied via the integrating amplifier (11) to the control input of the voltage-controlled oscillator (8), the voltage-controlled oscillator (8) being configured to tune the frequency of its output signal to the resonance frequency of the LC oscillating circuit (12) based on the determined phase deviation;
- a regulating amplifier (9), whose input is connected to a second output of the first sensor (2);
- a power amplifier (6) and an adjustable attenuating element (7), wherein the signal input of the adjustable attenuating element (7) is connected to the output of the voltage-controlled oscillator (8) and
- wherein the control input of the adjustable attenuating element (7) is connected to the output of the regulating amplifier (9) for setting the power level of the signal applied via the power amplifier (6) to the LC oscillating circuit (12) such that it remains at a reference value;
said device being arranged such that the reactance of the inductor at the resonance frequency of the LC oscillating circuit (12) matches the reactance of the capacitor to be tested (1).

## Patentansprüche

1. Die Vorrichtung zum automatischen Testen von Leistungskondensatoren umfasst
- eine Induktionsspule (3), die so angeordnet ist, dass sie zusammen mit dem zu testenden Kondensator (1) einen Parallel- oder Serien- LC-Schwingkreis (12) bildet, wenn der zu testende Kondensator (1) an die Vorrichtung angeschlossen ist;
- einen ersten Sensor (2), der konfiguriert ist, um das Strom- oder Spannungssignal an dem zu messenden Kondensator (1) zu überwachen;
- einen zweiten Sensor (4), der zum Überwachen von Strom oder Spannung über den LC-Schwingkreis (12) konfiguriert ist;
- einen Phasendetektor (10), dessen erster und zweiter Eingang mit den Ausgängen des ersten Sensors(2) und des zweiten Sensors (4) verbunden sind, wobei der Phasendetektor (10) eingestellt ist, um die Phasenverschiebung zwischen den Ausgangssignalen des ersten Sensors (2) und des zweiten Sensors (4) zu erfassen und um die Abweichung der genannten Phasenverschiebung von 90° zu bestimmen;
- einen Integrationsverstärker (11) und einen spannungsgesteuerten Oszillator (8), die so konfiguriert sind, dass das Ausgangssignal des Phasendetektors (10) über den Integrationsverstärker (11) an den Steuereingang des spannungsgesteuerten Oszillators (8) geleitet wird, wobei der spannungsgesteuerte Oszillator (8) zur Abstimmung der Frequenz seines Ausgangssignals auf die Resonanzfrequenz LC des Schwingkreises (12) eingestellt ist, basierend auf der festgestellten Phasenabweichung;
- einen Regelverstärker (9), dessen Eingang mit dem zweiten Ausgang des ersten Sensors (2) verbunden ist;
- einen Leistungsverstärker (6) und ein steuerbares Dämpfungsglied (7), wobei der Signaleingang des steuerbaren Dämpfungsgliedes (7) mit dem Ausgang des spannungsgesteuerten Oszillators (8) und
- der Steuereingang des steuerbaren Dämpfungsgliedes (7) mit dem Ausgang des Regelverstärkers (9) verbunden ist, um den Leistungspegel des über den Leistungsverstärker (6) dem LC-Schwingkreis (12) zugeführten Signals einzustellen, damit dieses auf dem Referenzwert bleibt;
die genannte Vorrichtung ist so konfiguriert, dass die Reaktanz des Induktors bei Resonanzfrequenz des LC-Schwingkreises (12) der Reaktanz des zu testenden Kondensators (1) entspricht.

## Revendications

1. Dispositif pour le test automatique de condensateurs de puissance, comprenant
- un inducteur (3), arrangé de telle façon qu'il forme, conjointement avec le condensateur à tester (1), un circuit (12) oscillant LC parallèle ou en série, où le condensateur à tester (1) est raccordé au dispositif ;
- un premier capteur (2) arrangé pour contrôler un signal de courant ou de tension dans le condensateur à mesurer (1) ;
- un second capteur (4) arrangé pour contrôler un courant ou une tension dans le circuit (12) LC oscillant;
- un détecteur (10) de phase, dont la première et la seconde entrée sont raccordées aux sorties du premier capteur (2) et du second capteur (4), respectivement, le détecteur (10) de phase étant configuré pour détecter la différence de phase entre les signaux de sortie du premier capteur (2) et du second capteur (4) et pour déterminer la déviation de ladite différence de phase de 90° ;
- un amplificateur (11) intégrateur et un oscillateur (8) commandé en tension, arrangés de telle façon que la sortie du détecteur (10) de phase soit fournie par le biais de l'amplificateur (11) intégrateur vers l'entrée de commande de l'oscillateur (8) commandé en tension, l'oscillateur (8) commandé en tension étant configuré pour ajuster la fréquence de son signal de sortie à la fréquence de résonnance du circuit (12) oscillant LC basé sur la déviation de phase déterminée ;
- un amplificateur (9) de régulation, dont l'entrée est raccordée à une seconde sortie du premier capteur (2) ;
- un amplificateur (6) de puissance et un élément (7) d'atténuation réglable, où l'entrée du signal de l'élément (7) d'atténuation réglable est raccordée à la sortie de l'oscillateur (8) commandé en tension et
- où l'entrée de commande de l'élément (7) d'atténuation réglable est raccordée à la sortie de l'amplificateur (9) de régulation pour établir le niveau de puissance du signal appliqué par le biais de l'amplificateur (6) de puissance au circuit (12) oscillant LC de façon qu'il reste à une valeur de référence ;
ledit dispositif étant arrangé de telle façon que la réactance de l'inducteur à la fréquence de résonnance du circuit (12) oscillant LC corresponde à la réactance du condensateur à tester (1).
